# EUROPEAN PATENT APPLICATION

(11) **EP 4 593 000 A1**
(43) Date of publication of application: **30.07.2025**
(21) Application number: 23868380.9
(22) Date of filing: 03.08.2023
(51) Int. Cl.: G09G 3/3233, H10K 59/131, H10K 59/126, H10K 59/121, H01L 27/12

(54) **DISPLAY DEVICE**

(30) Priority: 19.09.2022 KR 20220118005; 22.02.2023 KR 20230023904
(71) Applicant: Samsung Display Co., Ltd., Yongin-si, Gyeonggi-do 17113 (KR)
(72) Inventor: HWANG, Sung Chan, Yongin-si, Gyeonggi-do 17113 (KR); KIM, Dong Hyun, Yongin-si, Gyeonggi-do 17113 (KR); KANG, Chul Kyu, Yongin-si, Gyeonggi-do 17113 (KR); SHIN, Hey Jin, Yongin-si, Gyeonggi-do 17113 (KR); CHOE, Seo Won, Yongin-si, Gyeonggi-do 17113 (KR); HYUN, Chae Han, Yongin-si, Gyeonggi-do 17113 (KR)
(74) Representative: Marks & Clerk LLP
(86) International application number: PCT/KR2023/011412
(87) International publication number: WO 2024/063320

(57) **Abstract**

A display device comprises a pixel. The pixel is electrically connected to a first power line, a second power line, and a data line. The pixel comprises: a first transistor; and a capacitor electrically connected between a gate electrode of the first transistor and one electrode of the first transistor. In a plan view, the data line extends in a second direction. The first power line extends in a first direction crossing the second direction and overlaps the data line and the gate electrode of the first transistor. The second power line extends in the second direction, overlaps the data line, and overlaps the gate electrode of the first transistor.

## Description

### Technical Field

The disclosure relates to a display device.

### Background Art

A display device includes pixels, and each of the pixels emits light based on a corresponding data signal among data signals provided through a data line.

### Detailed Description of Invention

### Technical Problem

A parasitic capacitance may exist between a component (for example, a gate electrode and a source electrode of a driving transistor) in a pixel and a data line, and the pixel may emit light with a luminance different from a desired luminance due to the parasitic capacitance. Accordingly, a defect such as a stain may occur in an image displayed on the display device, and display quality may be deteriorated.

An aspect of the disclosure is to provide a display device having improved display quality.

Aspects of the disclosure are not limited to the aspect described above, and other technical aspects which are not described will be clearly understood by those skilled in the art from the following description.

### Technical Solution

According to an embodiment, a display device may include a pixel that is electrically connected to a first power line, a second power line, and a data line. The pixel may include a first transistor, and a capacitor electrically connected between a gate electrode of the first transistor and an electrode of the first transistor. In a plan view, the data line may extend in a second direction, the first power line may extend in a first direction intersecting the second direction and overlap the data line and the gate electrode of the first transistor, and the second power line may extend in the second direction, overlap the data line, and overlap the gate electrode of the first transistor.

Each of the first power line and the second power line may overlap a channel area of the first transistor in a plan view.

The first power line may expand in the second direction in an area adjacent to the first transistor in a plan view.

The second power line may expand in the first direction in an area adjacent to the first transistor in a plan view.

The first power line and the second power line may be electrically connected to each other, and a constant voltage may be applied to the first power line and the second power line.

The first power line and the second power line may be electrically separated from each other, and different constant voltages may be applied to the first power line and the second power line.

The pixel may further include a second transistor electrically connected between the data line and the gate electrode of the first transistor, and each of the first power line and the second power line may not overlap the second transistor in a plan view.

The capacitor may include a first electrode, the first electrode and the first power line being disposed on a same layer, a second electrode disposed on the first electrode, a third electrode, the third electrode and the gate electrode of the first transistor being disposed on a same layer, and a fourth electrode disposed on the third electrode and electrically connected to the electrode of the first transistor.

A first capacitor may be disposed between the first electrode and the second electrode, a second capacitor may be disposed between the second electrode and the third electrode, a third capacitor may be disposed between the third electrode and the fourth electrode, and the first capacitor, the second capacitor, and the third capacitor may be electrically connected to each other in parallel to configure the capacitor.

The third electrode may be electrically connected to the first electrode through a first opening disposed in the second electrode, and the fourth electrode may be electrically connected to the second electrode through a second opening disposed in the third electrode.

The second electrode of the capacitor may overlap a semiconductor layer of the first transistor in a plan view, and the second electrode of the capacitor may configure a lower electrode of the first transistor.

The pixel may further include a hold capacitor disposed between the first power line and the second electrode of the capacitor.

The data line and the fourth electrode may be disposed on a same layer, and the second power line may be disposed on the fourth electrode.

The pixel may further include a light emitting element, and the second power line may be disposed between the capacitor and an anode electrode of the light emitting element and shield the capacitor.

According to an embodiment, a display device may include a pixel that is electrically connected to a first power line, a second power line, a third power line, and a data line. The pixel may include a first transistor, and a capacitor disposed between a gate electrode of the first transistor and an electrode of the first transistor. In a plan view, the first power line may extend in a first direction, and the data line, the second power line, and the third power line may extend in a second direction intersecting the first direction. The data line and the capacitor may be covered by the first power line, the second power line, and the third power line in a plan view.

The second power line and the third power line may be disposed on a same layer, and the second power line may overlap a portion of the capacitor, and the third power line may overlap a remaining portion of the capacitor in a plan view.

The first power line and the second power line may be electrically connected to each other, and a constant voltage may be applied to the first power line and the second power line.

The capacitor may include a first electrode, the first electrode and the first power line being disposed on a same layer, a second electrode disposed on the first electrode, a third electrode, the third electrode and the gate electrode of the first transistor being disposed on a same layer, and a fourth electrode disposed on the third electrode and electrically connected to the electrode of the first transistor.

The third electrode may be electrically connected to the first electrode through a first opening disposed in the second electrode, and the fourth electrode may be electrically connected to the second electrode through a second opening disposed in the third electrode.

The data line and the fourth electrode may be disposed on a same layer, and the second power line may be disposed on the fourth electrode.

Details of other embodiments are included in the detailed description and drawings.

### Advantageous Effects

In a display device according to embodiments of the disclosure, the first power line may be disposed under the data line and the first transistor (or a source node) to shield the first transistor and the data line adjacent thereto. The second power line may be disposed on the data line and the first transistor (or the source node) and may shield the data line and the first transistor. For example, the data line and the first transistor (or the source node) may be shielded in an upper direction and a lower direction by the first power line and the second power line. Therefore, an accurate data signal may be maintained in the first transistor (or between a gate electrode and a source electrode of the first transistor), sub-pixels may accurately emit light with a target luminance, and display quality of the display device may be improved.

An effect according to embodiments is not limited by the contents provided as examples above, and additional various effects are included in the specification.

### Description of Drawings

The above and other features of the disclosure will become more apparent by describing in further detail embodiments thereof with reference to the accompanying drawings, in which:
FIG. 1 is a schematic plan view illustrating a display device according to embodiments;
FIG. 2 is a schematic circuit diagram illustrating an embodiment of a sub-pixel included in the display device of FIG. 1;
FIG. 3 is a schematic circuit diagram illustrating an embodiment of a sub-pixel included in the display device of FIG. 1;
FIG. 4 is a schematic plan view illustrating an embodiment of the sub-pixels of FIG. 1;
FIG. 5 is a schematic plan view illustrating an embodiment of a semiconductor layer included in a first sub-pixel of FIG. 4;
FIG. 6 is an enlarged schematic plan view of a first area of FIG. 4;
FIG. 7 is a schematic cross-sectional view illustrating an embodiment of the first sub-pixel along line I-I' of FIG. 6;
FIG. 8 is a schematic cross-sectional view illustrating an example of the first sub-pixel along line II-II' of FIG. 6;
FIG. 9 is a schematic plan view illustrating an embodiment of the sub-pixels of FIG. 1; and
FIG. 10 is a schematic cross-sectional view illustrating a comparative example of a sub-pixel.

### Modes of the Invention

Since various changes may be applied to the disclosure and the disclosure may have various forms, only certain specific embodiments will be illustrated in the drawings and described in detail herein. In the following description, the singular forms also include the plural forms unless the context clearly includes otherwise.

In the specification and the claims, the term "and/or" is intended to include any combination of the terms "and" and "or" for the purpose of its meaning and interpretation. For example, "A and/or B" may be understood to mean any combination including "A, B, or A and B." The terms "and" and "or" may be used in the conjunctive or disjunctive sense and may be understood to be equivalent to "and/or."

For the purposes of this disclosure, the phrase "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z.

The term "connection" may include an electrical connection and/or a physical connection. As but one example, "connection" used based on a circuit diagram may mean an electrical connection.

Although the terms "first," "second," and the like are used to describe various components, these components are not limited by these terms. These terms are used only to distinguish one component from another component. Therefore, a first component described below may be a second component and still within the technical concept of the disclosure.

The term "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art.

When an element is described as "not overlapping" or to "not overlap" another element, this may include that the elements are spaced apart from each other, offset from each other, or set aside from each other or any other suitable term as would be appreciated and understood by those of ordinary skill in the art.

The disclosure is not limited to the embodiments disclosed below, and may be modified in various forms. In addition, each of the embodiments disclosed below may be implemented alone or in combination with at least one of other embodiments.

In the drawings, some components which are not directly related to a characteristic of the disclosure may be omitted to clearly represent the disclosure. In addition, some components in the drawings may be shown with a slightly exaggerated, size, ratio, and/or the like. Throughout the drawings, the same or similar components will be given by the same reference numerals and symbols as much as possible even though they are shown in different drawings, and repetitive descriptions will be omitted.

"About" or "approximately" or "substantially" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Unless otherwise defined or implied herein, all terms (including technical and scientific terms) used herein have the same meaning as commonly understood by one of ordinary skill in the art to which the disclosure pertains. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

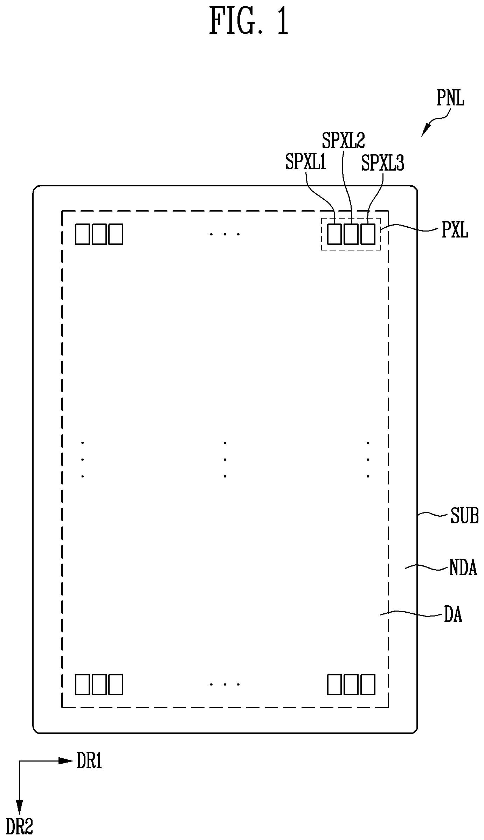

FIG. 1 is a schematic plan view illustrating a display device according to embodiments. In FIG. 1, as an example of an electronic device, a display device, in particular, a display panel PNL provided in the display device is shown.

For convenience, in FIG. 1, a structure of the display panel PNL is briefly shown based on a display area DA. However, according to an embodiment, at least one driving circuit unit (for example, at least one of a scan driver and a data driver), a line, and/or pads, which are/is not shown, may be further disposed on the display panel PNL.

The display device may be an electronic device in which a display surface is applied to at least one surface, such as a smartphone, a television, a tablet PC, a mobile phone, a video phone, an e-book reader, a desktop PC, a laptop PC, a netbook computer, a workstation, a server, a PDA, a portable multimedia player (PMP), an MP3 player, a medical device, a camera, or a wearable device.

Referring to FIG. 1, the display panel PNL may include a substrate SUB and a pixel PXL disposed on the substrate SUB.

The substrate SUB may configure a base member of the display panel PNL, and may be a rigid or flexible substrate or film. For example, the substrate SUB may be a rigid substrate formed of glass or tempered glass, a flexible substrate (or a thin film) of a plastic or metal material, and/or an insulating layer of at least one layer. The material and/or a material property of the substrate SUB are/is not particularly limited. The substrate SUB may be transparent or opaque. According to an embodiment, the substrate SUB may include a reflective material.

The display panel PNL and the substrate SUB for forming the display panel PNL may include the display area DA for displaying an image and a non-display area NDA except for the display area DA.

The pixel PXL may be disposed in the display area DA. Various lines, pads, and/or a built-in circuit unit connected to the pixel PXL of the display area DA may be disposed in the non-display area NDA.

The pixel PXL may include sub-pixels SPXL1 to SPXL3. For example, the pixel PXL may include a first sub-pixel SPXL1, a second sub-pixel SPXL2, and a third sub-pixels SPXL3.

Each of the sub-pixels SPXL1 to SPXL3 may emit light of a predetermined or selectable color. According to an embodiment, the sub-pixels SPXL1 to SPXL3 may emit light of different colors. For example, the first sub-pixel SPXL1 may emit light of a first color, the second sub-pixel SPXL2 may emit light of a second color, and the third sub-pixel SPXL3 may emit light of a third color. For example, the first sub-pixel SPXL1 may be a red pixel emitting red light, the second sub-pixel SPXL2 may be a green pixel emitting green light, and the third sub-pixel SPXL3 may be a blue pixel emitting blue light, but the disclosure is not limited thereto.

In an embodiment, the first sub-pixel SPXL1, the second sub-pixel SPXL2, and the third sub-pixel SPXL3 may include a light emitting element of the first color, a light emitting element of the second color, and a light emitting element of the third color as a light source, to emit light of the first color, the second color, and the third color, respectively. In another embodiment, the first sub-pixel SPXL1, the second sub-pixel SPXL2, and the third sub-pixel SPXL3 may include light emitting elements that emit light of the same color, and may include a color conversion layer and/or a color filter of different colors disposed on each light emitting element, to emit light of the first color, the second color, and the third color, respectively. However, the color, type, number, and/or the like of the sub-pixels SPXL1 to SPXL3 configuring each pixel PXL are/is not particularly limited. For example, the color of light emitted by each pixel PXL may be variously changed.

The sub-pixels SPXL1 to SPXL3 may be regularly arranged according to a stripe or PENTILE^{™} arrangement structure, and/or the like. For example, the first, second, and third sub-pixels SPXL1, SPXL2, and SPXL3 may be sequentially and repeatedly disposed along a first direction DR1 and may be repeatedly disposed along a second direction DR2. At least one of the first, second, and third sub-pixels SPXL1, SPXL2, and SPXL3 disposed adjacent to each other may configure one pixel PXL capable of emitting light of various colors. However, an arrangement structure of the sub-pixels SPXL1 to SPXL3 is not limited thereto, and the sub-pixels SPXL1 to SPXL3 may be arranged in the display area DA in various structures and/or methods.

In an embodiment, each of the sub-pixels SPXL1 to SPXL3 may be configured as an active type pixel. For example, each of the sub-pixels SPXL1 to SPXL3 may include at least one light source (for example, light emitting element) driven by a control signal (for example, a scan signal and a data signal) and/or predetermined or selectable power (for example, first power and second power). However, a type, a structure, and/or a driving method of the sub-pixels SPXL1 to SPXL3 applicable to the display device are/is not particularly limited.

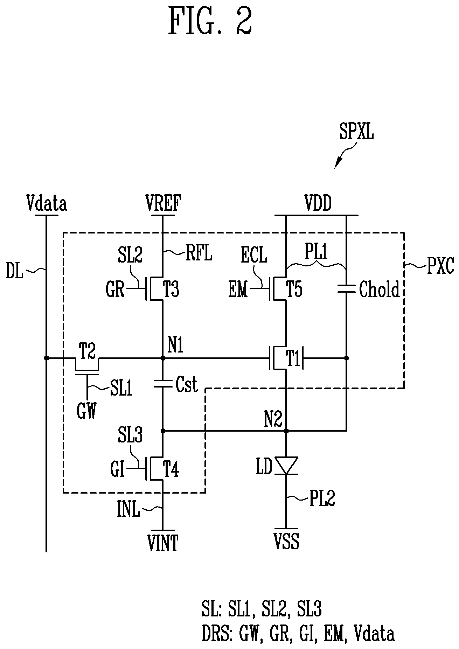

FIG. 2 is a schematic circuit diagram illustrating an embodiment of a sub-pixel included in the display device of FIG. 1. Since the sub-pixels SPXL1 to SPXL3 included in the display device of FIG. 1 may be substantially equal or similar to each other, the sub-pixel SPXL is described below by including sub-pixels SPXL1 to SPXL3.

Referring to FIGS. 1 and 2, the sub-pixel SPXL may be connected to a scan line SL (or a gate line), an emission control line ECL (or a first emission control line), and a data line DL. The scan line SL may include a first scan line SL1, a second scan line SL2, and a third scan line SL3. Driving signals DRS may be applied to the scan line SL, the emission control line ECL, and the data line DL. A first scan signal GW may be applied to the first scan line SL1, a second scan signal GR may be applied to the second scan line SL2, and a third scan signal GI may be applied to the third scan line SL3. An emission control signal EM (or a first emission control signal) may be applied to the emission control line ECL, and a data signal Vdata (or a data voltage) may be applied to the data line DL.

The pixel PXL may be further connected to a first power line PL1, a second power line PL2, a reference power line RFL, and an initialization power line INL (or a first initialization power line). A first power voltage VDD may be applied to the first power line PL1, a second power voltage VSS may be applied to the second power line PL2, a reference power voltage VREF may be applied to the reference power line RFL, and an initialization power voltage VINT (or a first initialization power voltage) may be applied to the initialization power line INL. Each of the first power voltage VDD, the second power voltage VSS, and the initialization power voltage VINT may be a constant voltage. Voltage levels of the first power voltage VDD, the second power voltage VSS, and the initialization power voltage VINT may be different from each other.

The pixel PXL may include a pixel circuit PXC and a light emitting element LD.

The pixel circuit PXC may include a first transistor T1 (or a driving transistor), a second transistor T2, and a first capacitor Cst (or a storage capacitor). In an embodiment, the pixel circuit PXC may further include a third transistor T3, a fourth transistor T4, a fifth transistor T5, and a second capacitor Chold (or a hold capacitor).

The first transistor T1 may be connected between the first power line PL1 and a second node N2 (or a source node). For example, a first electrode (for example, a drain electrode) of the first transistor T1 may be connected to the first power line PL1 via the fifth transistor T5, and a second electrode (for example, a source electrode) of the first transistor T1 may be connected to the second node N2. A gate electrode of the first transistor T1 may be connected to a first node N1. The first transistor T1 may further include a lower electrode, and the lower electrode may be connected to the second node N2. The first transistor T1 may supply a driving current to the light emitting element LD. For example, the first transistor T1 may supply a driving current corresponding to a voltage of the first node N1 to the light emitting element LD.

The second transistor T2 may be connected between the data line DL and the first node N1. A gate electrode of the second transistor T2 may be connected to the first scan line SL1. The second transistor T2 may be turned on in response to the first scan signal GW of the first scan line SL1. In the case that the second transistor T2 is turned on, the data signal Vdata of the data line DL may be transferred to the first node N1.

The third transistor T3 may be connected between the reference power line RFL and the first node N1. A gate electrode of the third transistor T3 may be connected to the second scan line SL2. The third transistor T3 may be turned on in response to the second scan signal GR of the second scan line SL2. In the case that the third transistor T3 is turned on, the reference power voltage VREF may be transferred to the first node N1. The first node N1 may be initialized by the reference power voltage VREF.

The fourth transistor T4 may be connected between the second node N2 and the initialization power line INL. A gate electrode of the fourth transistor T4 may be connected to the third scan line SL3. The fourth transistor T4 may be turned on in response to the third scan signal GI of the third scan line SL3. In the case that the fourth transistor T4 is turned on, the initialization power voltage VINT may be transferred to the second node N2. The second node N2 may be initialized by the initialization power voltage VINT.

The fifth transistor T5 may be connected between the first power line PL1 and the first transistor T1. A gate electrode of the fifth transistor T5 may be connected to the emission control line ECL. The fifth transistor T5 may be turned on in response to the emission control signal EM of the emission control line ECL. In the case that the fifth transistor T5 is turned on, a current path through which the driving current may flow from the first power line PL1 to the second power line PL2 via the pixel circuit PXC and the light emitting element LD may be formed.

The first capacitor Cst may be formed or connected between the first node N1 and the second node N2. A voltage corresponding to the data voltage Vdata may be stored in the first capacitor Cst.

The second capacitor Chold may be formed or connected between the first power line PL1 and the second node N2. The second capacitor Chold may stabilize a voltage of the second node N2.

The light emitting element LD may be connected between the second node N2 and the second power line PL2. For example, the light emitting element LD may be connected in a forward direction between the second node N2 and the second power line PL2. In the case that the driving current is supplied from the first transistor T1, the light emitting element LD may emit light with a luminance corresponding to the driving current.

In an embodiment, the light emitting element LD may include an organic light emitting diode. In another embodiment, the light emitting element LD may include at least one inorganic light emitting diode. A type, a size, and/or the number of light emitting elements LD may be changed according to an embodiment.

The first to fifth transistors T1 to T5 may be n-type transistors, but are not limited thereto. For example, at least one of the first to fifth transistors T1 to T5 may be changed to a p-type transistor. A voltage level of the driving signals DRS for controlling an operation of the transistor may be set according to the type of each transistor.

In an embodiment, at least one of the first to fifth transistors T1 to T5 may include an oxide semiconductor. For example, at least one transistor including the first transistor T1 may be an oxide semiconductor transistor including an oxide semiconductor.

A structure and a driving method of the sub-pixel SPXL may be variously changed. For example, the pixel circuit PXC may be configured with pixel circuits of various structures and/or driving methods in addition to the embodiment shown in FIG. 2.

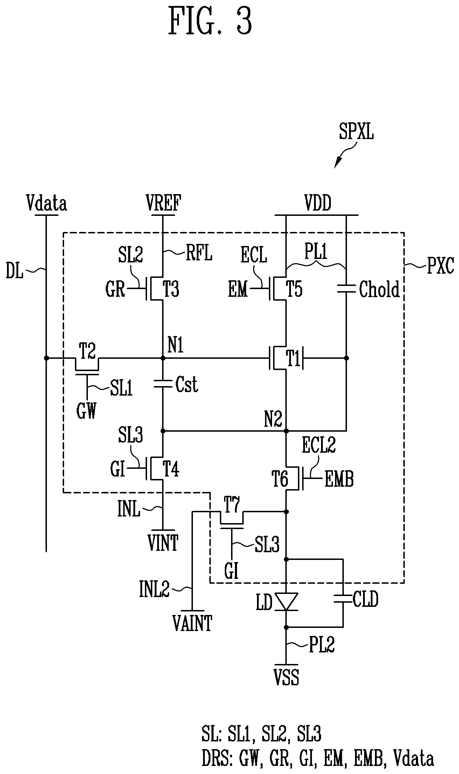

FIG. 3 is a schematic circuit diagram illustrating an embodiment of a sub-pixel included in the display device of FIG. 1.

Referring to FIGS. 2 and 3, the sub-pixel SPXL may be further connected to a second emission control line ECL2 and a second initialization power line INL2. A second emission control signal EMB may be applied to the second emission control line ECL2, and a second initialization power voltage VAINT may be applied to the second initialization power line INL2. The second initialization power voltage VAINT may be a constant voltage. The second initialization power voltage VAINT may be different from the initialization power voltage VINT of the initialization power line INL, but is not limited thereto.

The pixel circuit PXC may further include a sixth transistor T6 and a seventh transistor T7.

The sixth transistor T6 may be connected between the second node N2 and an anode electrode of the light emitting element LD. A gate electrode of the sixth transistor T6 may be connected to the second emission control line ECL2. The sixth transistor T6 may be turned on in response to the second emission control signal EMB of the second emission control line ECL2. In the case that the sixth transistor T6 is turned on, a current path through which the driving current may flow from the first power line PL1 to the second power line PL2 via the pixel circuit PXC and the light emitting element LD may be formed.

The seventh transistor T7 may be connected between the anode electrode of the light emitting element LD and the second initialization power line INL2. A gate electrode of the seventh transistor T7 may be connected to the third scan line SL3. The seventh transistor T7 may be turned on in response to the third scan signal GI of the third scan line SL3. In the case that the seventh transistor T7 is turned on, the second initialization power voltage VAINT may be transferred to the anode electrode of the light emitting element LD.

The light emitting element LD may have a capacitance, and the capacitance of the light emitting element LD may be expressed as a third capacitor CLD. In the pixel circuit PXC of FIG. 2, the second node N2 may be initialized by the initialization voltage VINT and the third capacitor CLD may be fully charged in the case that the driving current is supplied to the light emitting element LD. Accordingly, the light emitting element LD of FIG. 2 may emit light with a luminance slightly different from a desired luminance. In the pixel circuit PXC of FIG. 3, the second node N2 may be initialized by the initialization voltage VINT, and the light emitting element LD (for example, the light emitting element LD separated from the second node N2 by the sixth transistor T6) may be initialized by the second initialization power voltage VAINT. For example, the third capacitor CLD of the light emitting element LD may be charged by the second initialization power voltage VAINT, and the driving current may not be used in charging the third capacitor CLD. Therefore, the light emitting element LD may accurately emit light with a desired luminance.

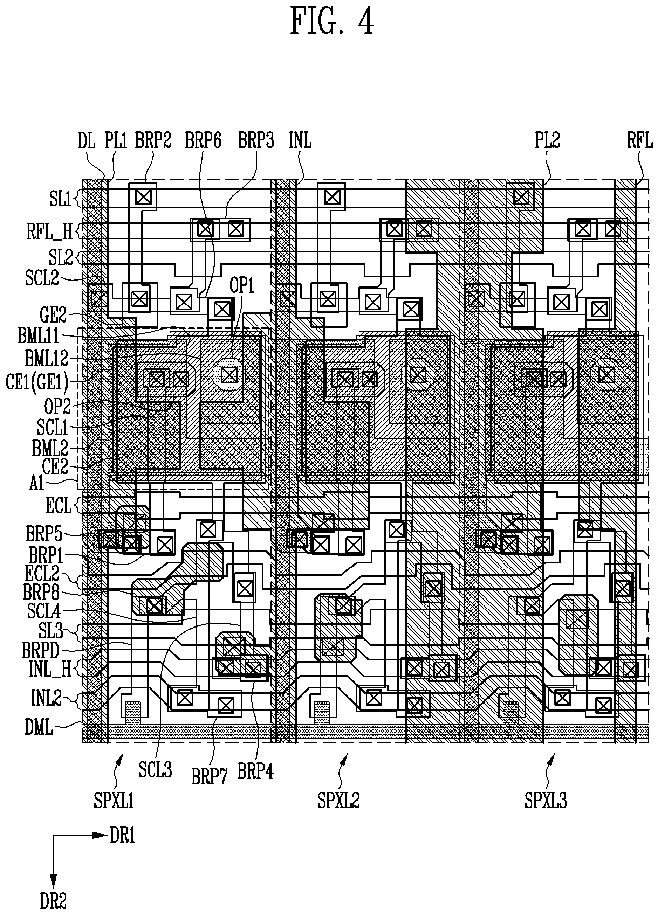

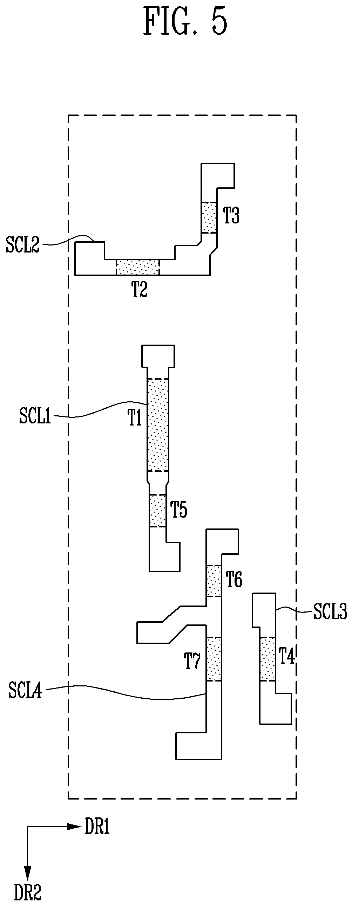

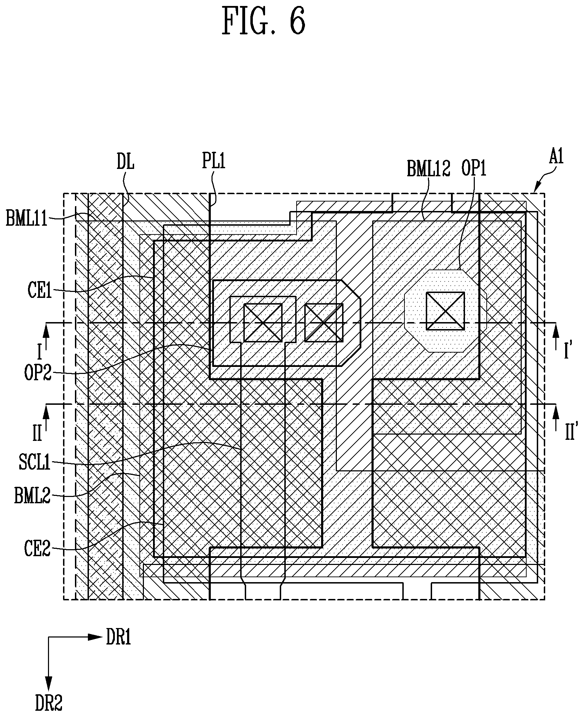

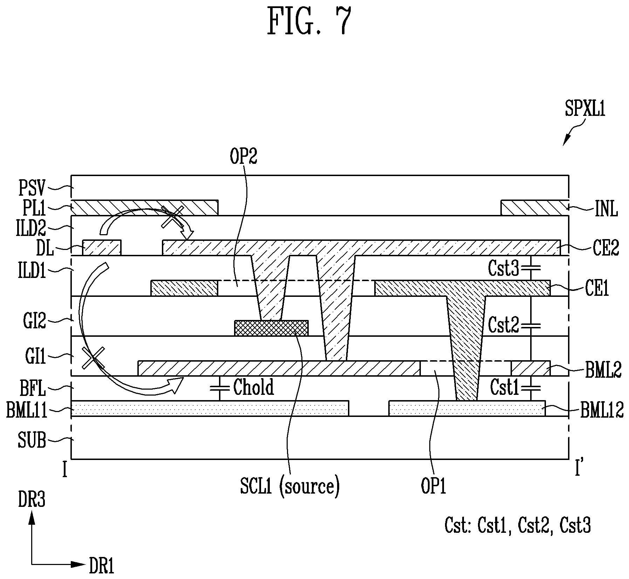

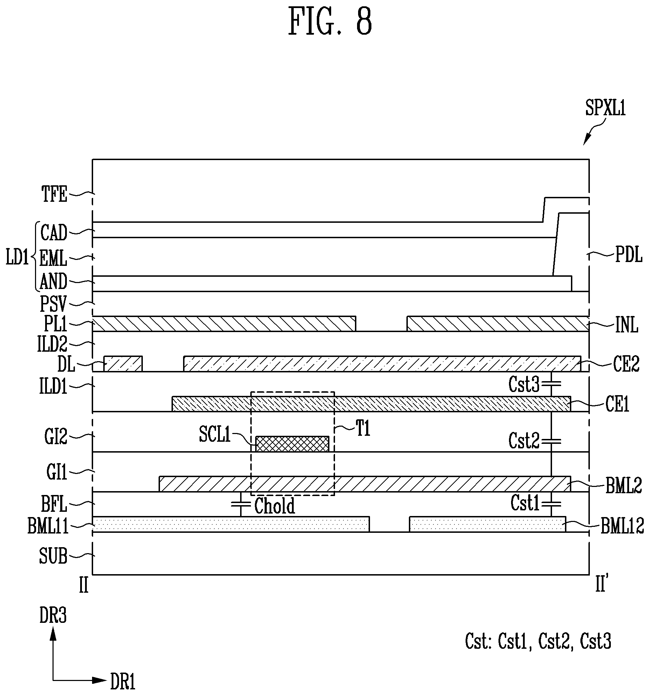

FIG. 4 is a schematic plan view illustrating an embodiment of the sub-pixels of FIG. 1. In FIG. 4, the sub-pixels SPXL1 to SPXL3 are shown based on the pixel circuit PXC of FIG. 3. For convenience of description, the sub-pixels SPXL1 to SPXL3 (or sub-pixel areas in which the sub-pixels SPXL1 to SPXL3 are disposed) are divided based on the pixel circuit in a plan view. FIG. 5 is a schematic plan view illustrating an embodiment of a semiconductor layer included in the first sub-pixel of FIG. 4. FIG. 6 is an enlarged schematic plan view of a first area of FIG. 4. FIG. 7 is a cross-sectional view illustrating an embodiment of the first sub-pixel along line I-I' of FIG. 6. FIG. 8 is a schematic cross-sectional view illustrating an example of the first sub-pixel along line II-II' of FIG. 6. Compared to FIG. 7, FIG. 8 further shows a first light emitting element LD1.

In FIGS. 4 to 8, the sub-pixel is simplified such as showing each electrode as a single layer of electrode and showing each insulating layer as a single layer of insulating layer, but the disclosure is not limited thereto.

In describing embodiments of the disclosure, "formed and/or provided in the same layer" may mean formed in the same process, and "formed in and/or provided in different layers" may mean formed in different processes.

In FIGS. 4 to 8, a width direction (or a horizontal direction) in a plan view is indicated as the first direction DR1, a height direction (or a vertical direction) in a plan view is indicated as the second direction DR2, and a thickness direction of the substrate SUB is indicated as a third direction DR3.

Referring to FIGS. 4 to 8, since the first sub-pixel SPXL1, the second sub-pixel SPXL2, and the third sub-pixel SPXL3 have pixel circuits (or circuit structures) substantially equal or similar to each other, a common configuration of the first sub-pixel SPXL1, the second sub-pixel SPXL2, and the third sub-pixel SPXL3 is described based on the first sub-pixel SPXL1, and an overlapping description is not repeated.

Hereinafter, with reference to FIG. 8, components are described according to a stack order on the substrate SUB.

An eleventh conductive pattern BML11 (or a first horizontal power line), a twelfth conductive pattern BML12, and a repair line DML may be disposed on the substrate SUB.

In a central area of the first sub-pixel SPXL1 based on the second direction DR2, the eleventh conductive pattern BML11 may extend in the first direction DR1. The eleventh conductive pattern BML11 may cross or intersect the first sub-pixel SPXL1, the second sub-pixel SPXL2, and the third sub-pixel SPXL3. In an area where the eleventh conductive pattern BML11 and the first power line PL1 overlap, the eleventh conductive pattern BML11 may be electrically connected to the first power line PL1 through the first bridge pattern BRP1 and a fifth bridge pattern BRP5. The eleventh conductive pattern BML11 may not be connected to the initialization power line INL and the second power line PL2.

A width of the second direction DR2 of the eleventh conductive pattern BML11 may vary according to a position. The eleventh conductive pattern BML11 may expand in a direction opposite to the second direction DR2 in an area adjacent to the data line DL and the first transistor T1. As will be described later, the eleventh conductive pattern BML11 may overlap the gate electrode (and the channel area) and the source electrode (the second electrode, or the source node) of the first transistor T1 and the data line DL, and may shield the gate electrode and the second electrode of the first transistor T1 and the data line DL. For example, the eleventh conductive pattern BML11 may prevent the gate electrode and the source electrode (or the source node) of the first transistor T1 from being affected by signal transferal of the data line DL adjacent to the gate electrode and the source electrode (or the source node) of the first transistor T1 (or coupling) (refer to FIGS. 7 and 8). Therefore, an accurate data signal may be maintained between the gate electrode and the source electrode of the first transistor T1, and the sub-pixel may accurately emit light with a target luminance.

The twelfth conductive pattern BML12 may be disposed to correspond to a section in which the width of the eleventh conductive pattern BML11 is relatively small. The twelfth conductive pattern BML12 may be disposed in an island shape.

The repair line DML may be positioned adjacent to a lower side of the first sub-pixel SPXL1 and may extend in the first direction DR1. In the case that a pixel circuit of the first sub-pixel SPXL1 is defective, the repair line DML may be a configuration for connecting the first sub-pixel SPXL1 (or a light emitting element of the first sub-pixel SPXL1) to a dummy pixel (or a dummy pixel circuit). According to an embodiment, the repair line DML may be omitted.

The eleventh conductive pattern BML11, the twelfth conductive pattern BML12, and the repair line DML may include a conductive material. For example, the conductive material may include copper (Cu), molybdenum (Mo), tungsten (W), aluminium neodymium (AlNd), titanium (Ti), aluminium (Al), silver (Ag), and/or an alloy thereof. The eleventh conductive pattern BML11, the twelfth conductive pattern BML12, and the repair line DML may have a single layer, double layer, or multiple layer structure.

The buffer layer BFL may be provided on the substrate SUB to cover the eleventh conductive pattern BML11, the twelfth conductive pattern BML12, and the repair line DML. The buffer layer BFL may be an inorganic insulating layer including an inorganic material. For example, the inorganic material may include at least one of silicon nitride (SiNₓ), silicon oxide (SiOₓ), silicon oxynitride (SiOₓN_{y}), and metal oxides such as aluminum oxide (AlOₓ). The buffer layer BFL may be provided as a single layer, but may be provided as multiple layers of at least double layers. In the case that the buffer layer BFL is provided as multiple layers, each layer may be formed of the same material or different materials.

The second conductive pattern BML2 may be disposed on the buffer layer BFL and may overlap the eleventh conductive pattern BML11 and the twelfth conductive pattern BML12. The second conductive pattern BML2 may be disposed in an island shape. The second conductive pattern BML2 may include a conductive material.

As shown in FIGS. 7 and 8, the second conductive pattern BML2 may overlap the eleventh conductive pattern BML11 and configure the second capacitor Chold. For example, the second capacitor Chold may be formed between the second conductive pattern BML2 and the eleventh conductive pattern BML11. The second conductive pattern BML2 may overlap a first semiconductor pattern SCL1 and may configure a lower electrode of the first transistor T1. The second conductive pattern BML2 may overlap the twelfth conductive pattern BML12 and configure a first sub-capacitor Cst1. The first sub-capacitor Cst1 may configure the first capacitor Cst together with a second sub-capacitor Cst2 and a third sub-capacitor Cst3. A capacitance (or capacity) of the first capacitor Cst may be increased or maximized.

A first gate insulating layer GI1 may be disposed on the second conductive pattern BML2. The first gate insulating layer GI1 may include an inorganic material. Various materials imparting an insulating property to the first gate insulating layer GI1 may be applied. For example, the first gate insulating layer GI1 may include an organic material. The first gate insulating layer GI1 may be provided as a single layer, but may also be provided as multiple layers of at least double layers.

The semiconductor patterns SCL1 to SCL4 may be disposed on the first gate insulating layer GI1. The semiconductor patterns SCL1 to SCL4 may be semiconductor patterns formed of amorphous silicon, poly silicon, low temperature poly silicon, an oxide semiconductor, an organic semiconductor, and/or the like.

The first semiconductor pattern SCL1 may extend in the second direction DR2. The first semiconductor pattern SCL1 overlapping a first capacitor electrode CE1 may configure a channel area of the first transistor T1, and the first semiconductor pattern SCL1 overlapping the emission control line ECL may configure a channel area of the fifth transistor T5. The channel area may be, for example, a semiconductor pattern which is not doped with an impurity, and may be an intrinsic semiconductor. An area except for the channel area (for example, a remaining area of the first semiconductor pattern SCL1) may be a semiconductor pattern doped with an impurity.

The second semiconductor pattern SCL2 may be positioned on the first semiconductor pattern SCL1. The second semiconductor pattern SCL2 overlapping a second gate electrode GE2 may configure a channel area of the second transistor T2, and the second semiconductor pattern SCL2 overlapping the second scan line SL2 may configure a channel area of the third transistor T3.

The third semiconductor pattern SCL3 and the fourth semiconductor pattern SCL4 may be positioned under the first semiconductor pattern SCL1. The third semiconductor pattern SCL3 overlapping the third scan line SL3 may configure a channel area of the fourth transistor T4. The fourth semiconductor pattern SCL4 overlapping the second emission control line ECL2 may configure a channel area of the sixth transistor T6, and the fourth semiconductor pattern SCL4 overlapping the third scan line SL3 may configure a channel area of the seventh transistor T7. According to an embodiment, for example, in the sub-pixel SPXL of FIG. 2, the fourth semiconductor pattern SCL4 may be omitted.

A second gate insulating layer GI2 may be disposed on the semiconductor patterns SCL1 to SCL4. The second gate insulating layer GI2 may include an inorganic material or an organic material and may be provided as a single layer or multiple layers.

The first capacitor electrode CE1 (or a first gate electrode GE1), a second gate electrode GE2, the first scan line SL1, a horizontal reference power line RFL_H, the second scan line SL2, the emission control line ECL, a first bridge pattern BRP1, the second emission control line ECL2, the third scan line SL3, a horizontal initialization power line INL_H, and the second initialization power line INL2 may be disposed on the second gate insulating layer GI2 (or the first gate insulating layer GI1). The first capacitor electrode CE1, the second gate electrode GE2, the first scan line SL1, the horizontal reference power line RFL_H, the second scan line SL2, the emission control line ECL, the first bridge pattern BRP1, the second emission control line ECL2, the third scan line SL3, the horizontal initialization power line INL_H, and the second initialization power line INL2 may include a conductive material.

The first capacitor electrode CE1 may overlap the second conductive pattern BML2. Most of the first capacitor electrode CE1 may overlap the second conductive pattern BML2. The first capacitor electrode CE1 overlapping the first semiconductor pattern SCL1 may configure the gate electrode of the first transistor T1.

As shown in FIGS. 7 and 8, the first capacitor electrode CE1 may overlap the second conductive pattern BML2 and form the second sub-capacitor Cst2. The first capacitor electrode CE1 may be connected to the twelfth conductive pattern BML12 through a first opening OP1 passing through the second conductive pattern BML2. Accordingly, the second sub-capacitor Cst2 and the first sub-capacitor Cst1 may be connected in parallel with each other.

The second gate electrode GE2 may overlap the second semiconductor pattern SCL2 and configure the gate electrode of the second transistor T2.

The first bridge pattern BRP1 may overlap the eleventh conductive pattern BML11 and may be connected to the eleventh conductive pattern BML11 through a contact hole.

The first scan line SL1, the horizontal reference power line RFL_H, the second scan line SL2, the emission control line ECL, the second emission control line ECL2, the third scan line SL3, the horizontal initialization power line INL_H, and the second initialization power line INL2 may extend in the first direction DR1 and may be arranged along the second direction DR2.

The first scan line SL1 may be electrically connected to the second gate electrode GE2 through a second bridge pattern BRP2.

The horizontal reference power line RFL_H may be connected to an upper end of the second semiconductor pattern SCL2 through a third bridge pattern BRP3. For example, the horizontal reference power line RFL_H may be electrically connected to an electrode of the third transistor T3.

The second scan line SL2 may overlap the second semiconductor pattern SCL2 and configure the gate electrode of the third transistor T3.

The emission control line ECL may overlap the first semiconductor pattern SCL1 and configure the gate electrode of the fifth transistor T5.

The emission control line ECL may overlap the first semiconductor pattern SCL1 and configure the gate electrode of the fifth transistor T5.

The second emission control line ECL2 may overlap the fourth semiconductor pattern SCL4 and configure the gate electrode of the sixth transistor T6.

The third scan line SL3 may overlap the fourth semiconductor pattern SCL4 and may configure the gate electrode of the seventh transistor T7. The third scan line SL3 may overlap the third semiconductor pattern SCL3 and configure the gate electrode of the fourth transistor T4.

The horizontal initialization power line INL_H may be connected to a lower end of the third semiconductor pattern SCL3 through a fourth bridge pattern BRP4. For example, the horizontal initialization power line INL_H may be electrically connected to an electrode of the fourth transistor T4.

The second initialization power line INL2 may be connected to a lower end of the fourth semiconductor pattern SCL4 through a seventh bridge pattern BRP7. For example, the second initialization power line INL2 may be electrically connected to an electrode of the seventh transistor T7.

A first interlayer insulating layer ILD1 may be disposed on the first capacitor electrode CE1, the second gate electrode GE2, the first scan line SL1, the horizontal reference power line RFL_H, the second scan line SL2, the emission control line ECL, the first bridge pattern BRP1, the second emission control line ECL2, the third scan line SL3, the horizontal initialization power line INL_H, and the second initialization power line INL2. The first interlayer insulating layer ILD1 may include an inorganic material or an organic material and may be provided as a single layer or multiple layers.

A second capacitor electrode CE2, the data line DL, the second bridge pattern BRP2, the third bridge pattern BRP3, the fourth bridge pattern BRP4, the fifth bridge pattern BRP5, a sixth bridge pattern BRP6, the seventh bridge pattern BRP7, and a dummy bridge pattern BRPD may be disposed on the first interlayer insulating layer ILD1. The second capacitor electrode CE2, the data line DL, the second bridge pattern BRP2, the third bridge pattern BRP3, the fourth bridge pattern BRP4, the fifth bridge pattern BRP5, the sixth bridge pattern BRP6, the seventh bridge pattern BRP7, and the dummy bridge pattern BRPD may include a conductive material.

The second capacitor electrode CE2 may overlap the first capacitor electrode CE1. Most of the first capacitor electrode CE1 may overlap the second capacitor electrode CE2. The second capacitor electrode CE2 may extend in the second direction DR2 and may be connected to an upper end of the third semiconductor pattern SCL3 and an upper end of the fourth semiconductor pattern SCL4 through a contact hole. For example, the second capacitor electrode CE2 may be electrically connected to an electrode of the fourth transistor T4 and an electrode of the sixth transistor T6.

As shown in FIGS. 7 and 8, the second capacitor electrode CE2 may overlap the first capacitor electrode CE1 and form the third sub-capacitor Cst3. The second capacitor electrode CE2 may be connected to the first semiconductor pattern SCL1 (or a source area of the first semiconductor pattern SCL1) through a second opening OP2 passing through the first capacitor electrode CE1. For example, the second capacitor electrode CE2 may be electrically connected to an electrode (for example, the source electrode) of the first transistor T1.

The second capacitor electrode CE2 may be connected to the second conductive pattern BML2 through the second opening OP2. Accordingly, the third sub-capacitor Cst3 and the second sub-capacitor Cst2 may be connected in parallel with each other.

The data line DL may extend in the second direction DR2 and may be repeatedly arranged along the first direction DR1. The data line DL may be connected to a left end of the second semiconductor pattern SCL2 through a contact hole. For example, the data line DL may be electrically connected to an electrode of the second transistor T2.

In an embodiment, the data line DL may not include a curved portion and may have a constant line width along the second direction DR2. In order to prevent the data line DL from affecting an adjacent component, the data line DL may have a partially curved shape, but in this case, a resistance of the data line DL may increase. In embodiments of the disclosure, since the data line DL and the adjacent component (for example, the first transistor T1) are shielded by the eleventh conductive pattern BML11 and power lines (for example, the first power line PL1 or the like), the data line DL may not include a curved portion.

The second bridge pattern BRP2 may overlap the first scan line SL1 and the second gate electrode GE2 and electrically connect the first scan line SL1 and the second gate electrode GE2 through a contact hole.

The third bridge pattern BRP3 may electrically connect an electrode of the third transistor T3 and the horizontal reference power line RFL_H through a contact hole.

The fourth bridge pattern BRP4 may overlap the horizontal initialization power line INL_H and the lower end of the third semiconductor pattern SCL3, and electrically connect the horizontal initialization power line INL_H to the lower end of the third semiconductor pattern SCL3 (for example, an electrode of the fourth transistor T4) through a contact hole.

The fifth bridge pattern BRP5 may overlap a lower end of the first semiconductor pattern SCL1 and the first bridge pattern BRP1, and may be connected to the first bridge pattern BRP1 and the lower end of the first semiconductor pattern SCL1 (for example, an electrode of the fifth transistor T5). The fifth bridge pattern BRP5 may be connected to the first power line PL1 to be described later. The first power line PL1 may be electrically connected to an electrode of the fifth transistor T5 through the fifth bridge pattern BRP5, and the first power line PL1 may be electrically connected to the eleventh conductive pattern BML11 through the fifth bridge pattern BRP5 and the first bridge pattern BRP1.

The sixth bridge pattern BRP6 may overlap the second semiconductor pattern SCL2 and the first capacitor electrode CE1, and electrically connect the second semiconductor pattern SCL2 (for example, a node between the second transistor T2 and the third transistor T3) and the first capacitor electrode CE1.

The seventh bridge pattern BRP7 may overlap the lower end of the third semiconductor pattern SCL3 and the horizontal initialization power line INL_H, and electrically connect the lower end of the third semiconductor pattern SCL3 (for example, an electrode of the fourth transistor T4) to the horizontal initialization power line INL_H. The seventh bridge pattern BRP7 may be connected to the initialization power line INL to be described later. The initialization power line INL may be electrically connected to the horizontal initialization power line INL_H through the seventh bridge pattern BRP7.

The dummy bridge pattern BRPD may overlap the fourth semiconductor pattern SCL4 and the repair line DML. The dummy bridge pattern BRPD may be connected to the fourth semiconductor pattern SCL4 (for example, a node between the sixth transistor T6 and the seventh transistor T7). The dummy bridge pattern BRPD may not be connected to the repair line DML. In other embodiments, in the case that the dummy bridge pattern BRPD is connected to the repair line DML, the dummy bridge pattern BRPD may electrically connect a dummy line to the node between the sixth transistor T6 and the seventh transistor T7.

A second interlayer insulating layer ILD2 may be disposed on the second capacitor electrode CE2, the data line DL, the second bridge pattern BRP2, the third bridge pattern BRP3, the fourth bridge pattern BRP4, the fifth bridge pattern BRP5, the sixth bridge pattern BRP6, the seventh bridge pattern BRP7, and the dummy bridge pattern BRPD. The second interlayer insulating layer ILD2 may include an inorganic material or an organic material and may be provided as a single layer or multiple layers.

The first power line PL1, the initialization power line INL, the second power line PL2, the reference power line RFL, and an eighth bridge pattern BRP8 may be disposed on the second interlayer insulating layer ILD2. The first power line PL1, the initialization power line INL, the second power line PL2, the reference power line RFL, and the eighth bridge pattern BRP8 may include a conductive material.

The first power line PL1, the initialization power line INL, the second power line PL2, and the reference power line RFL may generally extend in the second direction DR2, and the first power line PL1, the initialization power line INL, the second power line PL2, and the reference power line RFL may be arranged along the first direction DR1. The first power line PL1 may be disposed adjacent to a left side of the first sub-pixel SPXL1, the initialization power line INL may be disposed to correspond to a boundary between the first sub-pixel SPXL1 and the second sub-pixel SPXL2, the second power line PL2 may be disposed to correspond to a boundary between the second sub-pixel SPXL2 and the third sub-pixel SPXL3, and the reference power line RFL may be disposed adjacent to a right side of the first sub-pixel SPXL1.

Each of the first power line PL1, the initialization power line INL, and the second power line PL2 may overlap the data line DL and may shield the data line DL. The reference power line RFL may not overlap the data line DL. This is because the reference power voltage VREF of the reference power line RFL (and a voltage at the gate electrode of the first transistor T1 controlling the driving current) may be fluctuated by the data signal of the data line DL in the case that the reference power line RFL overlaps the data line DL.

The first power line PL1 may overlap the fifth bridge pattern BRP5 and may be connected to the fifth bridge pattern BRP5 through a contact hole. The first power line PL1 may be electrically connected to the eleventh conductive pattern BML11 through the fifth bridge pattern BRP5 and the first bridge pattern BRP1. The eleventh conductive pattern BML11 and the first power line PL1 may form a mesh structure throughout the display device.

The first power line PL1 may partially overlap the second capacitor electrode CE2. The first power line PL1 may overlap the gate electrode (and the channel area) of the first transistor T1, shield the gate electrode and the source electrode of the first transistor T1 (the second capacitor electrode CE2 connected to the source electrode, or the source node), and prevent the gate electrode and the source electrode (or the source node) of the first transistor T1 from being affected by signal transferal of the data line DL (refer to FIGS. 7 and 8). To this end, the first power line PL1 may expand in the first direction DR1 in an area adjacent to the first transistor T1. The first power line PL1 may not overlap the second to seventh transistors T2 to T7, but is not limited thereto.

In an area where the initialization power line INL and the horizontal initialization power line INL_H intersect, the initialization power line INL may be electrically connected to the horizontal initialization power line INL_H through the fourth bridge pattern BRP4. The initialization power line INL and the horizontal initialization power line INL_H may form a mesh structure throughout the display device.

The initialization power line INL may expand in the first direction DR1 in an area adjacent to the first transistor T1 (or the first transistor T1 of the second sub-pixel SPXL2), and partially overlap the second capacitor electrode CE2. For example, the initialization power line INL may partially overlap the second capacitor electrode CE2 of the first sub-pixel SPXL1 (for example, a remaining portion of the second capacitor electrode CE2 which is not covered by the first power line PL1). For example, the second capacitor electrode CE2 of the first sub-pixel SPXL1 may be generally shielded by the initialization power line INL and the first power line PL1. Similarly to the first power line PL1, the initialization power line INL may partially overlap the second capacitor electrode CE2 of the second sub-pixel SPXL2.

Similarly to the first power line PL1 and the initialization power line INL, the second power line PL2 may partially overlap the second capacitor electrode CE2. For example, the second power line PL2 may overlap the second capacitor electrode CE2 of the second sub-pixel SPXL2 (for example, a remaining portion of the second capacitor electrode CE2 which is not covered by the initialization power line INL). For example, the second capacitor electrode CE2 of the second sub-pixel SPXL2 may be generally shielded by the second power line PL2 and the initialization power line INL. The second power line PL2 may partially overlap the second capacitor electrode CE2 of the third sub-pixel SPXL3.

In an area where the reference power line RFL and the horizontal reference power line RFL_H intersect, the reference power line RFL may be electrically connected to the horizontal reference power line RFL_H through a bridge pattern (for example, a bridge pattern corresponding to the third bridge pattern BRP3). The reference power line RFL and the horizontal reference power line RFL_H may form a mesh structure throughout the display device. The reference power line RFL may overlap the second capacitor electrode CE2 of the third sub-pixel SPXL3 (for example, a remaining portion of the second capacitor electrode CE2 which is not covered by the second power line PL2). For example, the second capacitor electrode CE2 of the third sub-pixel SPXL3 may be generally shielded by the reference power line RFL and the second power line PL2.

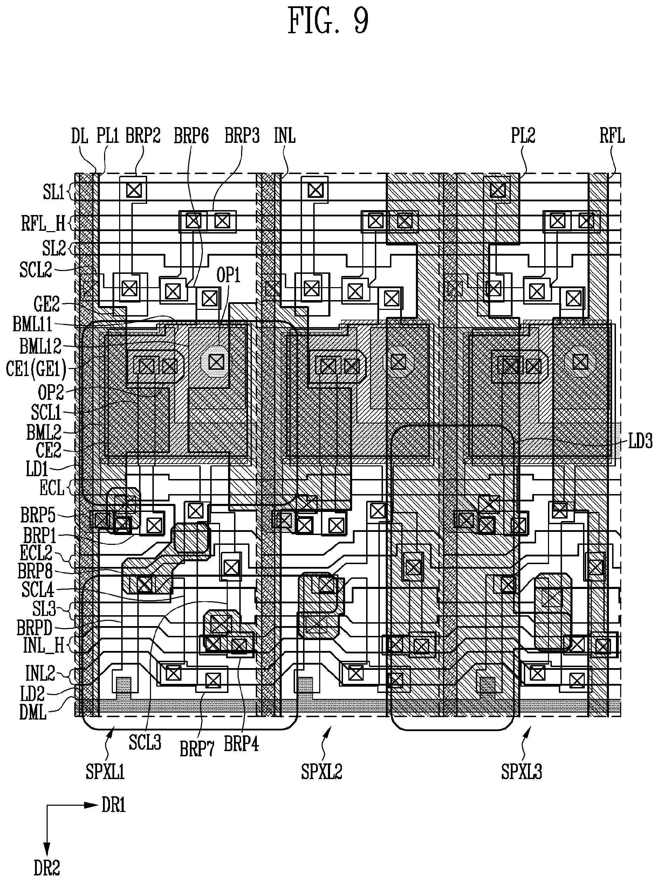

The eighth bridge pattern BRP8 may overlap the dummy bridge pattern BRPD. The eighth bridge pattern BRP8 may be electrically connected to the fourth semiconductor pattern SCL4 (for example, the node between the sixth transistor T6 and the seventh transistor T7) through the dummy bridge pattern BRPD. The eighth bridge pattern BRP8 may be connected to the light emitting element (refer to FIGS. 8 and 9). For example, the eighth bridge pattern BRP8 may electrically connect the light emitting element to the node between the sixth transistor T6 and the seventh transistor T7.

A protective layer PSV may be disposed on the first power line PL1, the initialization power line INL, the second power line PL2, the reference power line RFL, and the eighth bridge pattern BRP8. The protective layer PSV may include an organic material and/or an inorganic material. For example, the organic material may include polyacrylates resin, epoxy resin, phenolic resin, polyamides resin, polyimides resin, unsaturated polyester resin, poly-phenylen ethers resin, poly-phenylene sulfides resin, and/or benzocyclobutene resin.

The light emitting element may be disposed on the protective layer PSV.

In an embodiment, in the first sub-pixel SPXL1, the first light emitting element LD1 may be disposed on the protective layer PSV, and the first light emitting element LD1 may be an organic light emitting diode. The first light emitting element LD1 may include a first pixel electrode AND (or an anode electrode), an emission layer EML, and a second pixel electrode CAD (or a cathode electrode).

The first pixel electrode AND may be disposed on the protective layer PSV. The first pixel electrode AND may be electrically connected to the eighth bridge pattern BRP8 through a contact hole passing through the protective layer PSV (refer to FIG. 9).

A pixel defining layer PDL may include an opening, and at least a portion of the first pixel electrode AND may be exposed through the opening. The pixel defining layer PDL may include an organic material.

The emission layer EML may be disposed on the first pixel electrode AND, and the second pixel electrode CAD may be disposed on the emission layer EML.

At least one of the first pixel electrode AND and the second pixel electrode CAD may be a transmissive electrode. For example, when the display device is a front surface emission type display device, the first pixel electrode AND may be a reflective electrode and the second pixel electrode CAD may be a transmissive electrode.

The emission layer EML may be disposed on an exposed surface of the first pixel electrode AND. The emission layer EML may have a multiple layer thin film structure including at least a light generation layer. For example, the emission layer EML may include a hole injection layer that injects a hole, a hole transport layer having excellent hole transport properties and for increasing a chance of recombination of a hole and an electron by suppressing a movement of an electron that is not combined in the light generation layer, the light generation layer that emits light by the recombination of the injected electron and hole, a hole blocking layer for suppressing a movement of a hole that is not combined in the light generation layer, an electron transport layer for smoothly transporting the electron to the light generation layer, and an electron injection layer for injecting the electron.

The hole injection layer, the hole transport layer, the hole blocking layer, the electron transport layer, and the electron injection layer may each be a common layer connected in sub-pixels (or sub-pixel areas) adjacent to each other.

The second pixel electrode CAD may be disposed on the emission layer EML. The second pixel electrode CAD may be a transflective layer. For example, the second pixel electrode CAD may be a thin metal layer having a thickness sufficient to transmit light. The second pixel electrode CAD may transmit a portion of the light generated in the light generation layer and reflect the rest of the light generated in the light generating layer.

A portion of light emitted from the emission layer EML may not pass through the second pixel electrode CAD, and light reflected from the second pixel electrode CAD may be reflected from the first pixel electrode AND again. For example, the light emitted from the emission layer EML may resonate between the first pixel electrode AND and the second pixel electrode CAD. Light extraction efficiency of the first light emitting element LD1 may be improved by the resonance of light.

A thin film encapsulation layer TFE may be disposed on the first light emitting element LD1.

The thin film encapsulation layer TFE may be disposed on the second pixel electrode CAD. The thin film encapsulation layer TFE may be commonly disposed in the sub-pixels SPXL. The thin film encapsulation layer TFE may directly cover the second pixel electrode CAD.

The thin film encapsulation layer TFE may include a first inorganic layer, an organic layer, and a second inorganic layer stacked on each other on the second pixel electrode CAD.

As described above, the eleventh conductive pattern BML11 may be disposed under the data line DL and the second conductive pattern BML2, and the eleventh conductive pattern BML11 may shield the data line DL and the second conductive pattern BML2 (or the source node). The first power line PL1, the initialization power line INL, and the second power line PL2 may be disposed on the second capacitor electrode CE2, and may shield the data line DL and the second capacitor electrode CE2 (or the source node). Therefore, an accurate data signal may be maintained between the gate electrode and the source electrode of the first transistor T1, the sub-pixel may accurately emit light with a target luminance, and display quality of the display device may be improved.

The embodiment of FIGS. 4 to 8 may also be applied to the sub-pixel SPXL of FIG. 2. For example, in the embodiment of FIGS. 4 to 8, by removing the sixth transistor T6 and the seventh transistor T7 (and the second initialization power line VAINT and the second control line EMB), the sub-pixel SPXL of FIG. 3 may be implemented.

FIG. 9 is a schematic plan view illustrating an embodiment of the sub-pixels of FIG. 1.

Referring to FIGS. 4, 8, and 9, except for the light emitting elements LD1 to LD3, the sub-pixels SPXL1 to SPXL3 of FIG. 9 may be substantially the same as the sub-pixels SPXL1 to SPXL3 of FIG. 4, and thus an overlapping description is not repeated.

The first light emitting element LD1 may overlap the second capacitor electrode CE2 of the first sub-pixel SPXL1. The first light-emitting element LD1 (or the first pixel electrode AND of the first light emitting element LD1, refer to FIG. 8) may be connected to the eighth bridge pattern BRP8 of the first sub-pixel SPXL1.

In an area where the first light emitting element LD1 and the second capacitor electrode CE2 of the first sub-pixel SPXL2 overlap, most of the second capacitor electrode CE2 may be covered or shielded by the first power line PL1 and the initialization power line INL. Based on the data line DL, the first power line PL1 and the initialization power line INL may shield the first light emitting element LD1 (or the anode electrode of the first light emitting element LD1).

The second light emitting element LD2 may be disposed under the first light emitting element LD1. The second light emitting element LD2 (or the first pixel electrode AND of the second light emitting element LD2, refer to FIG. 8) may be connected to a bridge pattern of the second sub-pixel SPXL2 (for example, a bridge pattern corresponding to the eighth bridge pattern BRP8).

The third light emitting element LD3 may partially overlap a pixel circuit of the second sub-pixel SPXL2 and a pixel circuit of the third sub-pixel SPXL3. The second power line PL2 may be disposed under the third light emitting element LD3, and the second power line PL2 may cover or shield a configuration under the third light emitting element LD3 (for example, the first transistor and a storage capacitor). Based on the data line DL, the second power line PL2 may shield the third light emitting element LD3 (or the anode electrode of the third light emitting element LD3).

A disposition of the light emitting elements LD1 to LD3 shown in FIG. 9 is an example, and is not limited to FIG. 9, and the disposition of the light emitting elements LD1 to LD3 may be variously changed. For example, each of the light emitting elements LD1 to LD3 may be disposed on a pixel circuit of a corresponding sub-pixel.

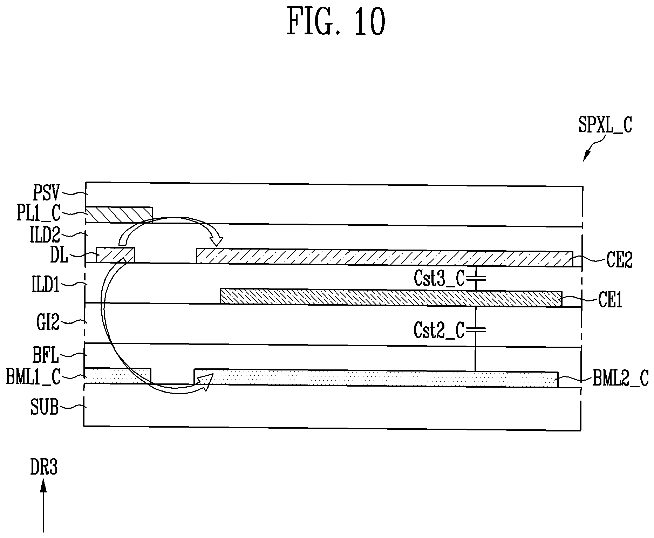

FIG. 10 is a schematic cross-sectional view illustrating a comparative example of a sub-pixel. FIG. 10 may correspond to FIG. 7. Similar reference numerals are assigned to components similar to those of FIG. 4, and an overlapping description is not repeated.

Referring to FIGS. 7 and 10, the sub-pixel SPXL_C of FIG. 10 may include a first conductive pattern BML1_C, a second conductive pattern BML2_C, the second capacitor electrode CE2, the data line DL, and a first power line PL1_C.

The second conductive pattern BML2_C and the first capacitor electrode CE1 spaced apart with the buffer layer BFL and the second gate insulating layer GI2 interposed therebetween may configure a second capacitor Cst2_C. The first capacitor electrode CE1 and the second capacitor electrode CE2 may configure a third capacitor Cst3_C. The second capacitor electrode CE2 and the second conductive pattern BML2 may be electrically connected, and the second capacitor Cst2_C and the third capacitor Cst3_C may be connected in parallel.

The first conductive pattern BML1_C may be disposed on the same layer as the second conductive pattern BML2_C. The second conductive pattern BML2_C may not be shielded by the first conductive pattern BML1_C. Therefore, the second conductive pattern BML2_C (or a source node) may be connected to the data line DL or affected by signal transferal of the data line DL.

The first power line PL1_C may be disposed on the data line DL, but may not overlap the second capacitor electrode CE2. The second capacitor electrode CE2 may not be shielded by the first power line PL1_C. Therefore, the second capacitor electrode CE2 (or a source node) of the sub-pixel SPXL_C may be connected to the data line DL or affected by signal transferal of the data line DL.

Compared to the sub-pixel SPXL_C of FIG. 10, in the first sub-pixel SPXL1 (refer to FIGS. 7 and 8) according to embodiments of the disclosure, the eleventh conductive pattern BML11 may be disposed under the second conductive pattern BML2, and the second conductive pattern BML2 (for example, the source node) may be shielded by the eleventh conductive pattern BML11. Since the twelfth conductive pattern BML12 disposed on the same layer as the eleventh conductive pattern BML11 configures the first sub-capacitor Cst1, the capacitance of the first capacitor Cst may be increased or maximized. Furthermore, the first power line PL1 and the initialization power line INL (the second power line PL2, and the reference power line RFL) may also be disposed on the second capacitor electrode CE2, and the second capacitor electrode CE2 (or the source node) may be shielded. Therefore, the first transistor (or the source node) may be prevented from being affected (or coupling) by the signal transferal of the data line DL adjacent to the first transistor (or the source node), and an accurate data signal may be written and maintained between the gate electrode and the source electrode of the first transistor, and the sub-pixel may accurately emit light with a target luminance.

Embodiments have been disclosed herein, and although terms are employed, they are used and are to be interpreted in a generic and descriptive sense only and not for purpose of limitation. In some instances, as would be apparent by one of ordinary skill in the art, features, characteristics, and/or elements described in connection with an embodiment may be used singly or in combination with features, characteristics, and/or elements described in connection with other embodiments unless otherwise specifically indicated. Accordingly, it will be understood by those of ordinary skill in the art that various changes in form and details may be made without departing from the spirit and scope of the disclosure.

## Claims

1. A display device comprising:
a pixel that is electrically connected to a first power line, a second power line, and a data line, the pixel comprising:
a first transistor; and
a capacitor electrically connected between a gate electrode of the first transistor and an electrode of the first transistor, wherein, in a plan view:
the data line extends in a second direction,
the first power line extends in a first direction intersecting the second direction and overlaps the data line and the gate electrode of the first transistor, and
the second power line extends in the second direction, overlaps the data line, and overlaps the gate electrode of the first transistor.

2. The display device according to claim 1, wherein each of the first power line and the second power line overlap a channel area of the first transistor in a plan view.

3. The display device according to claim 2, wherein the first power line expands in the second direction in an area adjacent to the first transistor in a plan view.

4. The display device according to claim 2, wherein the second power line expands in the first direction in an area adjacent to the first transistor in a plan view.

5. The display device according to claim 1, wherein
the first power line and the second power line are electrically connected to each other, and
a constant voltage is applied to the first power line and the second power line.

6. The display device according to claim 1, wherein
the first power line and the second power line are electrically separated from each other, and
different constant voltages are applied to the first power line and the second power line.

7. The display device according to claim 1, wherein
the pixel further comprises a second transistor electrically connected between the data line and the gate electrode of the first transistor, and
each of the first power line and the second power line does not overlap the second transistor in a plan view.

8. The display device according to claim 1, wherein the capacitor comprises:
a first electrode, the first electrode and the first power line being disposed on a same layer;
a second electrode disposed on the first electrode;
a third electrode, the third electrode and the gate electrode of the first transistor being disposed on a same layer; and
a fourth electrode disposed on the third electrode and electrically connected to the electrode of the first transistor.

9. The display device according to claim 8, wherein
a first capacitor is disposed between the first electrode and the second electrode,
a second capacitor is disposed between the second electrode and the third electrode,
a third capacitor is disposed between the third electrode and the fourth electrode, and
the first capacitor, the second capacitor, and the third capacitor are electrically connected to each other in parallel to configure the capacitor.

10. The display device according to claim 8, wherein
the third electrode is electrically connected to the first electrode through a first opening disposed in the second electrode, and
the fourth electrode is electrically connected to the second electrode through a second opening disposed in the third electrode.

11. The display device according to claim 8, wherein
the second electrode of the capacitor overlaps a semiconductor layer of the first transistor in a plan view, and
the second electrode of the capacitor configures a lower electrode of the first transistor.

12. The display device according to claim 11, wherein the pixel further comprises a hold capacitor disposed between the first power line and the second electrode of the capacitor.

13. The display device according to claim 8, wherein
the data line and the fourth electrode are disposed on a same layer, and
the second power line is disposed on the fourth electrode.

14. The display device according to claim 13, wherein
the pixel further comprises a light emitting element, and
the second power line is disposed between the capacitor and an anode electrode of the light emitting element and shields the capacitor.

15. A display device, comprising:
a pixel that is electrically connected to a first power line, a second power line, a third power line, and a data line, wherein
the pixel comprises:
a first transistor; and
a capacitor disposed between a gate electrode of the first transistor and an electrode of the first transistor,
in a plan view, the first power line extends in a first direction, and the data line, the second power line, and the third power line extend in a second direction intersecting the first direction, and
the data line and the capacitor are covered by the first power line, the second power line, and the third power line in a plan view.

16. The display device according to claim 15, wherein
the second power line and the third power line are disposed on a same layer,
the second power line overlap a portion of the capacitor, and
the third power line overlaps a remaining portion of the capacitor in a plan view.

17. The display device according to claim 16, wherein
the first power line and the second power line are electrically connected to each other, and
a constant voltage is applied to the first power line and the second power line.

18. The display device according to claim 15, wherein the capacitor comprises:
a first electrode, the first electrode and the first power line being disposed on a same layer;
a second electrode disposed on the first electrode;
a third electrode, the third electrode and the gate electrode of the first transistor being disposed on a same layer; and
a fourth electrode disposed on the third electrode and electrically connected to the electrode of the first transistor.

19. The display device according to claim 18, wherein
the third electrode is electrically connected to the first electrode through a first opening disposed in the second electrode, and
the fourth electrode is electrically connected to the second electrode through a second opening disposed in the third electrode.

20. The display device according to claim 18, wherein
the data line and the fourth electrode are disposed on a same layer, and
the second power line is disposed on the fourth electrode.
